# FASCICULE DE BREVET EUROPEEN

(11) **EP 3 839 626 B1**
(45) Date de publication et mention de la délivrance du brevet: **11.10.2023**
(21) Numéro de dépôt: 19217376.3
(22) Date de dépôt: 18.12.2019
(51) Int. Cl.: G03F 7/00, B81C 99/00, G04D 3/00, C25D 1/00, C25D 5/02, G04B 13/02, G04B 15/14, G04B 19/06, G04B 19/12

(54) **PROCEDE DE FABRICATION D'UN COMPOSANT HORLOGER**
VERFAHREN ZUR HERSTELLUNG EINER UHRKOMPONENTE
METHOD FOR MANUFACTURING A TIMEPIECE COMPONENT

(43) Date de publication de la demande: 23.06.2021
(73) Titulaire: Nivarox-FAR S.A., 2400 Le Locle (CH)
(72) Inventeur: CUSIN, Pierre, 1423 Villars-Burquin (CH); GANDELHMAN, Alex, 2013 Colombier (CH); MUSY, Michel, 2552 Orpund (CH); GOLFIER, Clare, 2520 La Neuveville (CH)
(74) Mandataire: ICB SA

(56) Documents cités:
- WO-A1-2010/020515
- WO-A1-2013/182615
- JP-A- 2006 161 138
- BACHER W ET AL: "THE LIGA TECHNIQUE AND ITS POTENTIAL FOR MICROSYSTEMS - A SURVEY", IEEE TRANSACTIONS ON INDUSTRIAL ELECTRONICS, IEEE SERVICE CENTER, PISCATAWAY, NJ, USA, vol. 42, no. 5, 1 octobre 1995 (1995-10-01), - 31 octobre 1995 (1995-10-31), pages 431-441, XP000542368, ISSN: 0278-0046, DOI: 10.1109/41.464604

## Description

### Domaine de l'invention

La présente invention concerne un procédé de fabrication d'une structure métallique complexe multi-niveaux au moyen de la technologie LIGA. L'invention concerne également une telle structure métallique, notamment des composants horlogers, obtenus par ce procédé.

### Arrière-plan de l'invention

On connaît déjà des procédés correspondant à la définition ci-dessus. En particulier, l'article d'A. B. Frazier et al. intitulé « Metallic Microstuctures Fabricated Using Photosensitive Polyimide Electroplating molds » et publié dans le journal of Microelectromechanical systems (Vol. 2, N deg. 2, June 1993) décrit un procédé pour la fabrication de structures métalliques multi-niveaux par croissance galvanique dans des moules de polyimide réalisés par photolithographie de couches de résine photosensible. Ce procédé comprend les étapes suivantes :
- créer sur un substrat une couche métallique sacrificielle et une couche d'amorçage pour une étape ultérieure de croissance galvanique,
- étaler une couche de polyimide photosensible,
- irradier la couche de polyimide avec un rayonnement UV à travers un masque correspondant au contour d'un niveau de la structure à obtenir,
- développer la couche de polyimide en dissolvant les parties non irradiées de façon à obtenir un moule en polyimide,
- remplir le moule de nickel jusqu'à la hauteur de celui-ci par croissance galvanique, et obtenir une surface supérieure sensiblement plane,
- déposer une fine couche de chrome sur toute la surface supérieure par vaporisation sous vide,
- déposer sur la couche de chrome une nouvelle couche de résine photosensible,
- irradier la couche de résine à travers un nouveau masque correspondant au contour du niveau suivant de la structure à obtenir,
- développer la couche de polyimide de façon à obtenir un nouveau moule,
- remplir le nouveau moule de nickel jusqu'à la hauteur de celui-ci par croissance galvanique.
- séparer la structure multi-niveaux et le moule en polyimide de la couche sacrificielle et du substrat,
- séparer la structure multi-niveaux du moule en polyimide.

On comprendra que le procédé qui vient d'être décrit peut, en principe, être mis en oeuvre de manière itérative pour obtenir des structures métalliques ayant plus de deux niveaux.

Le document de brevet WO2010/020515A1 décrit la fabrication d'une pièce à plusieurs niveaux en réalisant un moule de photoresist complet correspondant à la pièce finale à obtenir avant l'étape de dépôt galvanique du métal de la pièce dans le moule. Seules des pièces multi-niveaux dont les projections des niveaux sont incluses l'une dans l'autre sont réalisables par cette méthode.

On connait également du document de brevet EP2405301A1, un moule en photoresist comprenant au moins deux niveaux, les niveaux formés dans le substrat ne comportant que des flancs verticaux et lisses.

Ces procédés ne permettent que la fabrication de pièces dont leurs géométries de base sont cylindriques, et ne permettent pas la fabrication de pièces comprenant des géométries complexes telles que des anglages ou des chanfreins.

La demande de brevet JP 2006 161138 A décrit également la fabrication d'une pièce à plusieurs niveaux en réalisant un moule en photoréserve correspondant à la pièce finale à obtenir avant l'étape de dépôt galvanique du métal de la pièce dans le moule en photoréserve. Ce moule en photoréserve est formé à l'aide d'un tampon d'emboutissage multi-niveaux.L'article de W. Bâcher et al. intitulé « The LIGA Technique and Its Potential for Microsystems - A Survey», publié dans le journal IEEE Transactions on Industrial Electronics (VOL. 42, No. 5, 1995), décrit un procédé de fabrication de microstructures multi-niveaux combinant la lithographie aux rayons X et l'électroformage. Un insert de moule métallique est utilisé pour modeler la surface supérieure d'une couche de réserve dans un procédé de moulage sous vide. Puis la surface inférieure de la couche de réserve est structurée par lithographie à rayons X. La réserve à deux niveaux obtenue est ensuite utilisée pour fabriquer un insert de moule par électroformage qui peut être utilisé pour le moulage de microstructures multi-niveaux.

### Résumé de l'invention

La présente invention a pour but de remédier aux inconvénients susmentionnés ainsi qu'à d'autres encore en fournissant un procédé permettant de fabriquer des composants horlogers métalliques multi-niveaux, en combinant une étape d'emboutissage à chaud à la technologie LIGA, dans lequel une couche conductrice est associée à une couche de résine pour chaque niveau pour permettre une croissance galvanique fiable dans le cas de composants multiniveaux.

La présente invention a également pour but de permettre la fabrication de pièces horlogères présentant des géométries complexes d'ordinaire infaisable via la technologie LIGA.

A cet effet l'invention a pour objet un procédé de fabrication d'un composant horloger comprenant les étapes suivantes :
a) se munir d'un substrat, y déposer une première couche électriquement conductrice, et appliquer une première couche de résine photosensible ;
b) effectuer un emboutissage à chaud via un tampon de la première couche de résine photosensible, en pressant le tampon jusqu'au substrat, pour la mettre en forme et définir un premier niveau du composant horloger ;
c) irradier la première couche de résine photosensible mise en forme à travers un masque définissant un premier niveau du composant horloger et dissoudre les zones non irradiées de la couche de résine photosensible pour faire apparaître par endroit la première couche électriquement conductrice ;
e) appliquer une deuxième couche de résine photosensible recouvrant la structure résultant de l'étape c), puis irradier la deuxième couche de résine photosensible à travers un masque définissant un deuxième niveau du composant et dissoudre les zones non irradiées de la deuxième couche de résine photosensible pour former un moule comprenant un premier et un second niveau ;
f) déposer une couche métallique par électroformage dans le moule à partir de la première couche électriquement conductrice pour former le composant horloger, la couche métallique atteignant sensiblement la surface supérieure de la deuxième couche de résine photosensible ;
g) éliminer successivement le substrat, la première couche électriquement conductrice et la résine photosensible pour libérer le composant horloger.

Ce procédé permet donc la réalisation de pièces multiniveaux.

Conformément à d'autres variantes avantageuses de l'invention :
- l'étape b) est réalisée sous vide.
- lors de l'étape b), la première couche de résine photosensible est chauffée entre 70°C et 150°C ;
- le tampon présente une empreinte en relief, au moins une partie de l'empreinte étant agencée pour être pressée directement contre la surface du substrat lors de l'étape b) ;
- ladite empreinte du tampon définit ledit au moins un premier niveau du composant horloger;
- le procédé comprend une étape optionnelle d'), à la suite de l'étape c), qui consiste à déposer localement une deuxième couche électriquement conductrice sur les zones irradiées de la première couche de résine photosensible;
- la deuxième couche électriquement conductrice est déposée à travers un masque chablon ;
- la deuxième couche électriquement conductrice est mise en oeuvre par dépôt global sur toutes les surfaces exposées (flancs compris) puis retirée intégralement sauf sur la surface supérieure de la première couche de résine photosensible, où elle a été protégée au moyen d'une épargne déposée par tamponnage ;
- la deuxième couche électriquement conductrice est déposée via l'impression d'une encre ou d'une résine conductrice ;
- ladite première couche et ladite deuxième couche électriquement conductrice sont du type Au, Ti, Pt, Ag, Cr, Pd ou un empilement d'au moins deux de ces matériaux ;
- le substrat est en silicium ;
- la première couche conductrice présente une épaisseur comprise entre 50nm et 500nm ;
- la deuxième couche conductrice présente une épaisseur comprise entre 50nm et 500nm.

L'invention a également pour objet un procédé de fabrication d'un composant horloger selon la revendication 2, des modes de réalisation particuliers étant définis par les revendications 3, 4 et 7 à 14, dans la mesure où ces dernières dépendent de la revendication 2.

Enfin, l'invention se rapporte à un composant horloger, obtenu selon un procédé conforme à l'invention, tel qu'une ancre ou une roue d'échappement par exemple.

On comprend donc que le procédé de l'invention trouve une application particulièrement avantageuse pour la fabrication de composants pour les pièces d'horlogerie.

### Description sommaire des dessins

D'autres caractéristiques et avantages de la présente invention ressortiront plus clairement de la description détaillée qui suit d'un exemple de réalisation d'un procédé selon l'invention, cet exemple étant donné seulement à titre purement illustratif et non limitatif, en liaison avec le dessin annexé sur lequel :

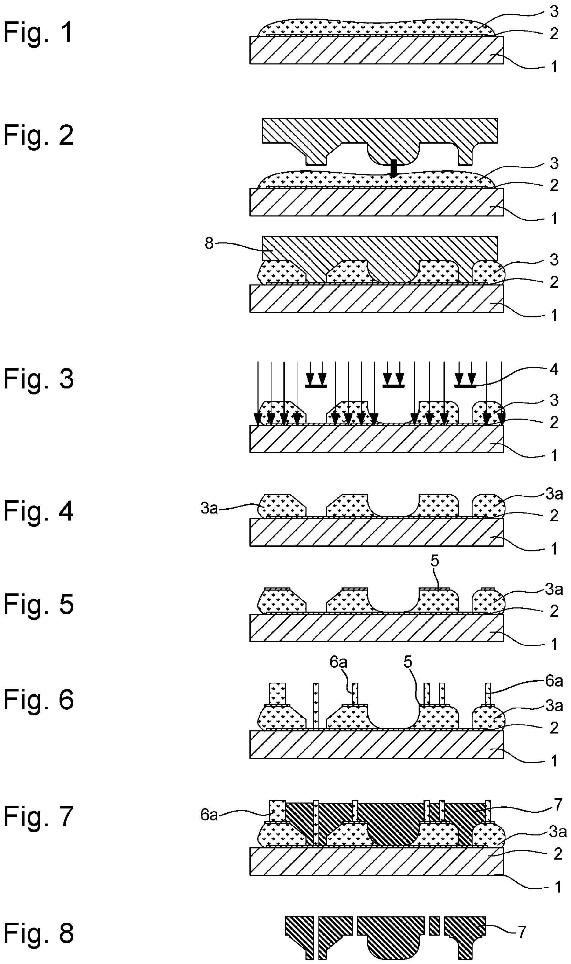

- les figures 1 à 8 illustrent les étapes de procédé d'un mode de réalisation de l'invention en vue de la réalisation d'un composant horloger.

### Description détaillée d'un mode de réalisation préféré

Le substrat 1 utilisé dans l'étape a) du procédé selon l'invention est, par exemple, formé par un substrat en silicium. Lors de la première étape a) du procédé on dépose, par exemple, par un dépôt physique en phase vapeur (PVD), une première couche conductrice 2, c'est-à-dire une couche apte à démarrer un dépôt métallique par voie galvanique. Typiquement, la première couche conductrice 2 est du type Au, Ti, Pt, Ag, Cr ou Pd (figure 1), ou un empilement d'au moins deux de ces matériaux, et présente une épaisseur comprise entre 50nm et 500nm. Par exemple, la première couche conductrice 2 peut être formée d'une sous couche de chrome ou de titane recouverte d'une couche d'or ou de cuivre.

La résine photosensible 3 utilisée dans ce procédé est de préférence une résine de type négative à base d'époxy octofonctionnelle telle que la résine SU-8 conçue pour polymériser sous l'action d'un rayonnement UV.

La résine photosensible 3 peut se présenter sous la forme d'un film sec, la résine est alors appliquée par laminage sur le substrat 1.

Alternativement, la résine photosensible pourrait être un photorésist positif qui est conçu pour se décomposer sous l'action d'un rayonnement UV. On comprendra que la présente invention ne se limite pas à quelques types particuliers de résine photosensible. L'homme du métier saura choisir une résine photosensible convenant à ses besoins parmi toutes les résines connues qui sont adaptées à la photolithographie par UV.

La première couche de résine 3 est déposée sur le substrat 1 par tout moyen approprié, par enduction centrifuge, à la tournette, ou encore par sprayage jusqu'à l'épaisseur souhaitée. Typiquement l'épaisseur de résine est comprise entre 10 µm et 1000 µm, et de préférence entre 30 µm et 300 µm. Selon l'épaisseur désirée et la technique de dépôt utilisée la première couche de résine 3 sera déposée en une ou plusieurs fois.

La première couche de résine 3 est ensuite chauffée typiquement entre 90 et 120° C pendant une durée dépendant de l'épaisseur déposée pour évacuer le solvant (étape de pre-bake). Ce chauffage sèche et durcit la résine.

L'étape b) suivante illustrée à la figure 2 consiste à effectuer un emboutissage à chaud de la première couche de résine 3 pour la mettre en forme et définir un premier niveau du composant horloger. La résine est dans un premier temps chauffée à une température comprise entre 70°C et 150°C où elle devient visqueuse pour permettre sa mise en forme en l'écrasant au moyen d'un tampon 8 venant la presser. Cette étape peut être réalisée sous vide pour éviter la formation de bulles d'air lors du pressage de la couche de résine 3. Selon l'invention, le tampon 8 est pressé jusqu'à écrasement complet, jusqu'au substrat 1 de manière qu'il ne reste qu'un film résiduel de résine au-dessus de la couche conductrice là où les parties du tampon ont été pressées contre le substrat.

Avantageusement, le tampon 8 présente une empreinte en relief pouvant présenter des variations de hauteur et permettant ainsi de définir au moins un premier niveau du composant, ledit au moins premier niveau présente ainsi une géométrie tridimensionnelle complexe qu'il n'est pas possible d'obtenir par un procédé LIGA classique.

Il peut également être envisagé de former deux niveaux ou plus au moyen du tampon.

L'étape c) suivante illustrée à la figure 3 consiste à irradier la première couche de résine 3 au moyen d'un rayonnement UV à travers un masque 4 définissant le premier niveau du composant à former et ainsi des zones photopolymérisées 3a et des zones non photopolymérisées 3b.

Cette étape permet de garantir que le film résiduel de résine restant après le pressage du tampon disparaît pour faire apparaître la couche conductrice, et permet de structurer la résine comme effectué usuellement en LIGA.

Une étape de recuit (étape de post-bake) de la première couche de résine 3 peut être nécessaire pour compléter la photopolymérisation induite par l'irradiation UV. Cette étape de recuit est effectuée de préférence entre 90°C et 95°C. Les zones photopolymérisées 3a deviennent insensibles à une grande majorité de solvants. Par contre, les zones non photopolymérisées pourront ultérieurement être dissoutes par un solvant.

Ensuite, on dissout les zones non photopolymérisées 3b de la première couche 3 de résine photosensible pour faire apparaître par endroit la première couche conductrice 2 du substrat 1 comme sur la figure 4. Cette opération est réalisée par dissolution des zones non photopolymérisées 3b au moyen d'un solvant adéquat, tel que le PGMEA (propylène glycol méthyle éthyle acétate). Un moule en résine photosensible photopolymérisées 3a, formé par la combinaison d'une opération d'emboutissage et de photolithographie, définissant le premier niveau du composant est ainsi obtenu.

Selon une étape d') optionnelle illustrée à la figure 5, on dépose une deuxième couche conductrice 5 sur les zones photopolymérisées 3a lors de l'étape précédente. Cette deuxième couche conductrice 5 peut présenter les mêmes caractéristiques que la première couche conductrice 2, à savoir qu'elle est du type Au, Ti, Pt, Ag, Cr, Pd ou un empilement d'au moins deux de ces matériaux, et présente une épaisseur comprise entre 50nm et 500nm.

Selon une première variante de l'invention, on utilise un masque chablon qui est positionné via un alignement optique. Un tel équipement permet de garantir un bon alignement du masque avec la géométrie des zones photopolymérisées 3a sur le substrat et ainsi garantir un dépôt uniquement sur la surface supérieure des zones photopolymérisées 3a tout en évitant un dépôt sur les flancs de la résine photopolymérisées 3a car le masque est maintenu au plus proche du substrat 1.

Selon une deuxième variante de l'invention, la deuxième couche électriquement conductrice est mise en oeuvre par dépôt global sur toutes les surfaces exposées (flancs compris) puis retirée intégralement sauf sur la surface supérieure de la première couche de résine, où elle a été protégée au moyen d'une épargne déposée par tamponnage.

L'homme du métier pourrait également envisager la mise en oeuvre d'une impression 3D pour déposer la deuxième couche conductrice 5.

De telles solutions permettent un dépôt sélectif et plus précis de la deuxième couche électriquement conductrice 5, et donc de n'avoir aucun dépôt sur les flancs de la résine photopolymérisées 3a.

L'étape e) suivante illustrée à la figure 6 consiste à déposer une deuxième couche 6 de résine photosensible recouvrant la structure résultant de l'étape précédente. La même résine est utilisée lors de cette étape, et l'épaisseur est supérieure à celle déposée lors de l'étape a). Généralement l'épaisseur varie en fonction de la géométrie du composant que l'on souhaite obtenir.

La suite consiste à irradier la deuxième couche 6 de résine à travers un masque 4" définissant un deuxième niveau du composant et dissoudre les zones 6b non irradiées de la deuxième couche 6 de résine photosensible. A la fin de cette étape (figure 6), on obtient un moule comprenant un premier et un second niveau laissant apparaître par endroit la première couche 2 électriquement conductrice et la deuxième couche 5 électriquement conductrice.

L'étape f) suivante illustrée à la figure 7 consiste à déposer dans le moule, par électroformage ou dépôt galvanique, une couche 7 d'un métal à partir des première couche 2 et éventuelle deuxième couche 5 électriquement conductrice jusqu'à former un bloc atteignant préférentiellement une hauteur inférieure à la hauteur du moule, cela permettant une meilleure tenue mécanique lors d'un usinage ultérieur. Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore, ou encore le nickel-tungstène. En général, la structure métallique multicouche est entièrement réalisée dans le même alliage ou métal. Toutefois, il est également possible de changer de métal ou d'alliage au cours de l'étape de déposition galvanique de manière à obtenir une structure métallique comportant au moins deux couches de natures différentes.

Les conditions d'électroformage, notamment la composition des bains, la géométrie du système, les tensions et densités de courant, sont choisis pour chaque métal ou alliage à électrodéposer selon les techniques bien connues dans l'art de l'électroformage.

La couche métallique 7 peut être usinée par un procédé mécanique de manière à obtenir une épaisseur prédéfinie par l'épaisseur du composant à réaliser. Selon la face sur laquelle cette opération doit être effectuée, la reprise peut être faite en wafer.

L'étape g) consiste à libérer le composant en éliminant par une succession d'étapes de gravure, humide ou sèche, le substrat, les couches conductrices ou les couches de résine, opérations familières à l'homme du métier. Par exemple la première couche conductrice 2 et le substrat 1 sont éliminés au moyen d'une gravure humide, ce qui permet de libérer le composant du substrat 1 sans l'endommager. Notoirement, le substrat en silicium peut être gravé avec une solution à base d'hydroxyde de potassium (KOH).

A l'issue de cette première séquence, on obtient un composant pris dans les première et deuxième couches de résine, la deuxième couche conductrice 5 étant également encore présente par endroit.

Une deuxième séquence consiste à éliminer la première couche 3 et la deuxième couche 6 de résine au moyen de gravures plasma O₂, espacées de gravures humides des couches métalliques intermédiaires.

A l'issue de cette étape, les composants obtenus peuvent être nettoyés, et éventuellement repris sur une machine-outil pour opérer des usinages ou une terminaison esthétique. A ce stade, les pièces peuvent être directement utilisées ou bien soumises à divers traitements décoratifs et/ou fonctionnels, typiquement des dépôts physiques ou chimiques.

Le procédé de l'invention trouve une application particulièrement avantageuse pour la fabrication de composants pour pièces d'horlogerie, tels que des ressorts, des ancres, des roues, des appliques, etc. Grâce à ce procédé, on peut réaliser des composants de forme plus diverses et présentant des géométries complexes que ceux obtenus via des opérations de photolithographie classiques. Un tel procédé permet également d'obtenir des composants robustes et qui présentent une bonne fiabilité au niveau des géométries.

## Revendications

1. Procédé de fabrication d'au moins un composant horloger comprenant les étapes suivantes :
a) se munir d'un substrat (1), y déposer une première couche électriquement conductrice (2), et appliquer une première couche de résine photosensible (3) ;
b) effectuer un emboutissage à chaud via un tampon (8) de la première couche de résine photosensible (3), en pressant le tampon (8) jusqu'au substrat, pour mettre en forme la première couche de résine photosensible (3) et définir un premier niveau du composant horloger ;
c) irradier la première couche de résine photosensible (3) mise en forme à travers un masque (4) définissant l'au moins un premier niveau du composant horloger et dissoudre les zones (3b) non irradiées de la première couche de résine photosensible (3) pour faire apparaître par endroit la première couche électriquement conductrice (2) ;
d) appliquer une deuxième couche de résine photosensible (6) recouvrant la structure résultant de l'étape c), puis irradier la deuxième couche de résine photosensible (6) à travers un masque (4") définissant un deuxième niveau du composant horloger et dissoudre les zones (6b) non irradiées de la deuxième couche de résine photosensible (6) pour former un moule comprenant un premier et un second niveau ;
e) déposer une couche métallique (7) par électroformage dans le moule à partir de la première couche électriquement conductrice (2) pour former le composant horloger, la couche métallique (7) atteignant sensiblement la surface supérieure de la deuxième couche de résine photosensible (6) ;
f) éliminer successivement le substrat, la première couche électriquement conductrice (2) et la première et deuxième couche de résine photosensible (3, 6) pour libérer le composant horloger.

2. Procédé de fabrication d'au moins un composant horloger comprenant les étapes suivantes :
a')se munir d'un substrat (1), y déposer une première couche électriquement conductrice (2), et appliquer une première couche de résine photosensible (3) ;
b')irradier la première couche de résine photosensible (3) à travers un premier masque (4) définissant au moins un premier niveau du composant horloger et dissoudre les zones (3b) non irradiées de la couche de résine photosensible (3) pour faire apparaître par endroit la première couche électriquement conductrice (2) ;
c') appliquer une deuxième couche de résine photosensible (6) recouvrant la structure résultant de l'étape b'),
d') effectuer un emboutissage à chaud via un tampon de la deuxième couche de résine photosensible (6) pour mettre en forme la deuxième couche de résine photosensible (6) et définir un deuxième niveau du composant horloger ;
e') irradier la deuxième couche de résine photosensible (6) mise en forme à travers un deuxième masque (4") définissant le deuxième niveau du composant horloger et dissoudre les zones (6b) non irradiées de la deuxième couche de résine photosensible (6) pour former un moule comprenant le premier et le second niveau ;
f') déposer une couche métallique (7) par électroformage dans le moule à partir de la première couche électriquement conductrice (2) pour former le composant, la couche métallique (7) atteignant sensiblement la surface supérieure de la deuxième couche de résine photosensible (6) ;
g') éliminer successivement le substrat, la première couche électriquement conductrice (2) et la première et deuxième couche de résine photosensible (3, 6) pour libérer le composant horloger.

3. Procédé selon la revendication 1 ou 2, **caractérisé en ce que** l'étape b) ou l'étape d') est réalisée sous vide.

4. Procédé selon la revendication 1 ou 2, **caractérisé en ce que** lors de l'étape b) ou l'étape d'), la première couche de résine photosensible est chauffée entre 70°C et 150°C.

5. Procédé selon l'une des revendications 1, 3 ou 4, **caractérisé en ce que** le tampon présente une empreinte en relief, au moins une partie de l'empreinte étant agencée pour être pressée directement contre la surface du substrat lors de l'étape b).

6. Procédé selon la revendication 5, **caractérisé en ce que** ladite empreinte du tampon définit ledit au moins un premier niveau du composant horloger.

7. Procédé selon la revendication 1 ou 2, **caractérisé en ce qu'**il comprend une étape optionnelle d'), à la suite de l'étape c) ou de l'étape b'), qui consiste à déposer localement une deuxième couche électriquement conductrice (5) sur les zones (3a) irradiées de la première couche de résine photosensible (3).

8. Procédé selon la revendication 7, **caractérisé en ce que** la deuxième couche électriquement conductrice (5) est déposée à travers un masque chablon (4').

9. Procédé selon la revendication 7, **caractérisé en ce que** lors de l'étape d'), et,- la deuxième couche électriquement conductrice (5) est mise en oeuvre par dépôt global sur toutes les surfaces exposées, flancs compris, puis retirée intégralement sauf sur la surface supérieure de la première couche de résine photosensible, où elle a été protégée au moyen d'une épargne déposée par tamponnage.

10. Procédé selon la revendication 7, **caractérisé en ce que** lors de l'étape d'), la deuxième couche électriquement conductrice (5) est déposée via l'impression d'une encre ou une résine conductrice.

11. Procédé selon l'une des revendications précédentes, **caractérisé en ce que** ladite première couche électriquement conductrice (2) et ladite deuxième couche électriquement conductrice (5) sont du type Au, Ti, Pt, Ag, Cr, Pd.

12. Procédé selon l'une des revendications précédentes, **caractérisé en ce que** le substrat (1) est en silicium.

13. Procédé selon l'une des revendications précédentes, **caractérisé en ce que** la première couche électriquement conductrice (2) présente une épaisseur comprise entre 50nm et 500nm.

14. Procédé selon l'une des revendications précédentes, **caractérisé en ce que** la deuxième couche électriquement conductrice (5) présente une épaisseur comprise entre 50nm et 500nm.

## Patentansprüche

1. Verfahren zur Herstellung mindestens einer Uhrkomponente, die folgenden Schritte umfassend:
a) Vorsehen eines Substrats (1), Abscheiden darauf einer ersten elektrisch leitenden Schicht (2), und Aufbringen einer ersten Schicht aus lichtempfindlichem Harz (3);
b) Durchführen einer Heiß-Metalldrückerei anhand eines Futters (8) der ersten Schicht aus lichtempfindlichem Harz (3), indem das Futter (8) bis zum Substrat gedrückt wird, um die erste Schicht aus lichtempfindlichem Harz (3) in Form zu bringen, und eine erste Ebene der Uhrkomponente zu definieren;
c) Bestrahlen der in Form gebrachten ersten Schicht aus lichtempfindlichem Harz (3) durch eine Maske (4) hindurch, welche die mindestens eine erste Ebene der Uhrkomponente definiert, und Auflösen der nicht bestrahlten Bereiche (3b) der ersten Schicht aus lichtempfindlichem Harz (3), um die erste elektrisch leitende Schicht (2) stellenweise zutage zu bringen;
d) Aufbringen einer zweiten Schicht aus lichtempfindlichem Harz (6), welche die aus Schritt c) resultierende Struktur abdeckt, danach Bestrahlen der zweiten Schicht aus lichtempfindlichem Harz (6) durch eine Maske (4") hindurch, welche eine zweite Ebene der Uhrkomponente definiert, und Auflösen der nicht bestrahlten Bereiche (6b) der zweiten Schicht aus lichtempfindlichem Harz (6), um eine Form zu bilden, welche eine erste und eine zweite Ebene umfasst;
e) Abscheiden einer Metallschicht (7) durch Elektroformung in der Form aus der ersten elektrisch leitenden Schicht (2), um die Uhrkomponente zu bilden, wobei die Metallschicht (7) im Wesentlichen die obere Oberfläche der zweiten Schicht aus lichtempfindlichem Harz (6) erreicht;
f) sukzessives Entfernen des Substrats, der ersten elektrisch leitenden Schicht (2) und der ersten und zweiten Schicht aus lichtempfindlichem Harz (3, 6), um die Uhrkomponente freizugeben.

2. Verfahren zur Herstellung mindestens einer Uhrkomponente, die folgenden Schritte umfassend:
a') Vorsehen eines Substrats (1), Abscheiden darauf einer ersten elektrisch leitenden Schicht (2), und Aufbringen einer ersten Schicht aus lichtempfindlichem Harz (3);
b')Bestrahlen der ersten Schicht aus lichtempfindlichem Harz (3) durch eine erste Maske (4) hindurch, welche mindestens eine erste Ebene der Uhrkomponente definiert, und Auflösen der nicht bestrahlten Bereiche (3b) der Schicht aus lichtempfindlichem Harz (3), um die erste elektrisch leitende Schicht (2) stellenweise zutage zu bringen;
c') Aufbringen einer zweiten Schicht aus lichtempfindlichem Harz (6), welche die aus Schritt b') resultierende Struktur abdeckt,
d') Durchführen einer Heiß-Metalldrückerei anhand eines Futters der zweiten Schicht aus lichtempfindlichem Harz (6), um die zweite Schicht aus lichtempfindlichem Harz (6) in Form zu bringen, und eine zweite Ebene der Uhrkomponente zu definieren;
e') Bestrahlen der in Form gebrachten zweiten Schicht aus lichtempfindlichem Harz (6) durch eine zweite Maske (4") hindurch, welche die zweite Ebene der Uhrkomponente definiert, und Auflösen der nicht bestrahlten Bereiche (6b) der zweiten Schicht aus lichtempfindlichem Harz (6), um eine Form zu bilden, welche die erste und die zweite Ebene umfasst;
f') Abscheiden einer Metallschicht (7) durch Elektroformung in der Form aus der ersten elektrisch leitenden Schicht (2), um die Komponente zu bilden, wobei die Metallschicht (7) im Wesentlichen die obere Oberfläche der zweiten Schicht aus lichtempfindlichem Harz (6) erreicht;
g') sukzessives Entfernen des Substrats, der ersten elektrisch leitenden Schicht (2) und der ersten und zweiten Schicht aus lichtempfindlichem Harz (3, 6), um die Uhrkomponente freizugeben.

3. Verfahren nach Anspruch 1 oder 2, **dadurch gekennzeichnet, dass** der Schritt b) oder der Schritt d') unter Vakuum durchgeführt wird.

4. Verfahren nach Anspruch 1 oder 2, **dadurch gekennzeichnet, dass** bei dem Schritt b) oder dem Schritt d') die erste Schicht aus lichtempfindlichem Harz zwischen 70 °C und 150 °C erhitzt wird.

5. Verfahren nach einem der Ansprüche 1, 3 oder 4, **dadurch gekennzeichnet, dass** das Futter eine Einprägung aufweist, wobei mindestens ein Teil der Einprägung angeordnet ist, um beim Schritt b) direkt an die Oberfläche des Substrats gepresst zu werden.

6. Verfahren nach Anspruch 5, **dadurch gekennzeichnet, dass** die Einprägung des Futters die mindestens eine erste Ebene der Uhrkomponente definiert.

7. Verfahren nach Anspruch 1 oder 2, **dadurch gekennzeichnet, dass** es einen optionalen Schritt d') im Anschluss an den Schritt c) oder den Schritt b') umfasst, der darin besteht, lokal eine zweite elektrisch leitende Schicht (5) auf die bestrahlten Bereiche (3a) der ersten Schicht aus lichtempfindlichem Harz (3) aufzubringen.

8. Verfahren nach Anspruch 7, **dadurch gekennzeichnet, dass** die zweite elektrisch leitende Schicht (5) durch eine Schablonenmaske (4') hindurch aufgebracht wird.

9. Verfahren nach Anspruch 7, **dadurch gekennzeichnet, dass** beim Schritt d') die zweite elektrisch leitende Schicht (5) durch globales Abscheiden auf allen freiliegenden Oberflächen, einschließlich der Flanken, aufgebracht, und dann, außer auf der oberen Oberfläche der ersten Schicht aus lichtempfindlichem Harz, vollständig entfernt wird, wo sie anhand eines durch Stempeln aufgebrachten Decklacks geschützt worden ist.

10. Verfahren nach Anspruch 7, **dadurch gekennzeichnet, dass** beim Schritt d') die zweite elektrisch leitende Schicht (5) über den Aufdruck einer leitenden Tinte oder eines leitenden Harzes aufgebracht wird.

11. Verfahren nach einem der vorstehenden Ansprüche, **dadurch gekennzeichnet, dass** die erste elektrisch leitende Schicht (2) und die zweite elektrisch leitende Schicht (5) vom Typ Au, Ti, Pt, Ag, Cr, Pd sind.

12. Verfahren nach einem der vorstehenden Ansprüche, **dadurch gekennzeichnet, dass** das Substrat (1) aus Silizium ist.

13. Verfahren nach einem der vorstehenden Ansprüche, **dadurch gekennzeichnet, dass** die erste elektrisch leitende Schicht (2) eine Dicke aufweist, welche zwischen 50 nm und 500 nm liegt.

14. Verfahren nach einem der vorstehenden Ansprüche, **dadurch gekennzeichnet, dass** die zweite elektrisch leitende Schicht (5) eine Dicke aufweist, welche zwischen 50 nm und 500 nm liegt.

## Claims

1. Method for manufacturing at least one timepiece component comprising the following steps of:
a) providing a substrate (1), depositing a first electrically conductive layer (2) thereon and applying a first photoresist layer (3);
b) hot-pressing the first photoresist layer (3) using a stamp (8), by pressing the stamp (8) down as far as the substrate, in order to shape the first photoresist layer and define a first level of the timepiece component;
c) irradiating the first shaped photoresist layer (3) through a mask (4) defining the at least one first level of the timepiece component and dissolving the non-irradiated areas (3b) of the first photoresist layer (3) to reveal, in places, the first electrically conductive layer (2);
d) applying a second photoresist layer (6) covering the structure produced in step c), then irradiating the second photoresist layer (6) through a mask (4") defining a second level of the timepiece component and dissolving the non-irradiated areas (6b) of the second photoresist layer (6) to form a mould comprising a first and a second level;
e) depositing a metal layer (7) in the mould by electroforming from the first electrically conductive layer (2) to form the timepiece component, the metal layer (7) substantially reaching the upper surface of the second photoresist layer (6);
f) successively removing the substrate, the first electrically conductive layer (2) and the first and second photoresist layers (3, 6) to release the timepiece component.

2. Method for manufacturing at least one timepiece component comprising the following steps of:
a') providing a substrate (1), depositing a first electrically conductive layer (2) thereon and applying a first photoresist layer (3);
b') irradiating the first photoresist layer (3) through a first mask (4) defining at least a first level of the timepiece component and dissolving the non-irradiated areas (3b) of the photoresist layer (3) to reveal, in places, the first electrically conductive layer (2);
c') applying a second photoresist layer (6) covering the structure produced in step c),
d') hot-pressing the second photoresist layer (6) using a stamp to shape the second photoresist layer (6) and define a second level of the timepiece component;
e') irradiating the second shaped photoresist layer (6) through a second mask (4") defining the second level of the timepiece component and dissolving the non-irradiated areas (6b) of the second photoresist layer (6) to form a mould comprising the first level and the second level;
f') depositing a metal layer (7) in the mould by electroforming from the first electrically conductive layer (2) to form the component, the metal layer (7) substantially reaching the upper surface of the second photoresist layer (6);
g') successively removing the substrate, the first electrically conductive layer (2) and the first and second photoresist layers (3, 6) to release the timepiece component.

3. Method according to claim 1 or 2, **characterised in that** step b) or step d') is carried out in a vacuum.

4. Method according to claim 1 or 2, **characterised in that** in step b) or step d'), the first photoresist layer is heated to between 70°C and 150°C.

5. Method according to any of claims 1, 3 or 4, **characterised in that** the stamp has a raised impression, at least part of the impression being arranged to be pressed directly against the surface of the substrate in step b).

6. Method according to claim 5, **characterised in that** said impression of the stamp defines said at least one first level of the timepiece component.

7. Method according to claim 1 or 2, **characterised in that** it comprises an optional step d'), after step c) or step b'), which consists in locally depositing a second electrically conductive layer (5) on the irradiated areas (3a) of the first photoresist layer (3).

8. Method according to claim 7, **characterised in that** the second electrically conductive layer (5) is deposited through a stencil mask (4').

9. Method according to claim 7, **characterised in that** in step d'), the second electrically conductive layer (5) is applied by comprehensive deposition on all the exposed surfaces, including the sidewalls, and then is entirely removed except from the upper surface of the first photoresist layer, where it was protected by means of a resist deposited by stamping.

10. Method according to claim 7, **characterised in that** in step d'), the second electrically conductive layer (5) is deposited by printing an ink or a conductive resin.

11. Method according to any of the preceding claims, **characterised in that** said first electrically conductive layer (2) and said second electrically conductive layer (5) are of the Au, Ti, Pt, Ag, Cr or Pd type.

12. Method according to any of the preceding claims, **characterised in that** the substrate (1) is made of silicon.

13. Method according to any of the preceding claims, **characterised in that** the first electrically conductive layer (2) has a thickness comprised between 50 nm and 500 nm.

14. Method according to any of the preceding claims, **characterised in that** the second electrically conductive layer (5) has a thickness comprised between 50 nm and 500 nm.
